## Europäisches Patentamt
## European Patent Office
## Office européen des brevets

(19)

(11) Veröffentlichungsnummer : **0 102 565**
**B1**

(12) **EUROPÄISCHE PATENTSCHRIFT**

(45) Veröffentlichungstag der Patentschrift :
23.12.87

(51) Int. Cl.⁴ : **G 01 R 1/073**

(21) Anmeldenummer : **83108084.1**

(22) Anmeldetag : **16.08.83**

(54) **Verfahren und Vorrichtung zur elektrischen Prüfung von Mikroverdrahtungen.**

(30) Priorität : **25.08.82 DE 3231598**

(43) Veröffentlichungstag der Anmeldung :
**14.03.84 Patentblatt 84/11**

(45) Bekanntmachung des Hinweises auf die Patenterteilung : **23.12.87 Patentblatt 87/52**

(84) Benannte Vertragsstaaten :
**CH DE FR GB LI**

(56) Entgegenhaltungen :
**ELEKTROTECHNISCHE ZEITSCHRIFT (E.T.Z.) Ausgabe A, Band 94, Nr. 2, 1973, Berlin L. BÖHME et al. "Lichtbogenstromabnehmer für Schnellbahnen", Seiten 128-130**
**IBM TECHNICAL DISCLOSURE BULLETIN, vol.14, no.5, October 1971; H.BOHLEN et al. "Tester for electric conductors", page 1601**

(73) Patentinhaber : **Siemens Aktiengesellschaft Berlin und München**
**Wittelsbacherplatz 2**
**D-8000 München 2 (DE)**

(72) Erfinder : **Doemens, Günter, Dr. Ing.**
**Föchinger Strasse 4**
**D-8150 Holzkirchen (DE)**
Erfinder : **Mengel, Peter, Dr. rer.nat.**
**Roggensteiner Allee 32**
**D-8031 Eichenau (DE)**

**Beschreibung**

Die Erfindung betrifft ein Verfahren zur elektrischen Prüfung von Mikroverdrahtungen, die im Rastermaß verdrahtet sind, zum Beispiel Leiterplatten, bei welchem in einem Hohlraum jeweils zwischen Rasterpunkten, die durch eine Leiterbahn der zu prüfenden Mikroverdrahtungen verbunden sind, und Elektroden durch Anlegen einer hinreichend hohen Gleichspannung an die Elektroden eine elektrische Durchgängigkeit der Leiterbahn anzeigende Gasentladung eintritt.

Die weitgehende Miniaturisierung in der Elektronik verlangt auch eine Verfeinerung der Leiterplattenstrukturen, insbesondere bei Mehrlagenschaltungen. Dies hat eine Abnahme des Rastermaßes der Anschlußpunkte zur Folge.

Zur elektrischen Prüfung von Leiterplatten werden Nadeladapter eingesetzt, bei denen in jedem Rasterpunkt ein federnder Kontaktstift in einem als Rasterkörper dienenden Trägerblock angeordnet ist. Bei diesen bekannten Kontaktierungsvorrichtungen bestehen die Abtastelemente aus den genannten Stiften, an denen separate Druckfedern angreifen. Der den abzutastenden Kontaktstellen zugewandte Endbereich der Stifte ist zu einer Spitze oder Schneide geformt, die eine gute Kontaktgebung gewährleisten soll. Die anderen Endbereiche der Stifte sind mit flexiblen elektrischen Leitern verbunden, die ihrerseits zu den äußeren elektrischen Anschlüssen der Kontaktiervorrichtung führen.

Eine derartige Anordnung hat den Nachteil, daß aufgrund des Platzbedarfes der einzelnen Kontaktierelemente bei zunehmender Verringerung des Rastermaßes erhebliche feinwerktechnische probleme auftreten. Bei Rastermaßen unter einem Millimeter sind an die Realisierbarkeit dieser Anordnungen deshalb deutliche Grenzen gesetzt. Die elektrische Prüfung von Leiterplatten mit diesen geringen Rastermaßen wird aufgrund der schwierigen Ankontaktierung zu einem noch weitgehend ungelösten Problem.

Aus der Druckschrift « IBM Technical Disclosure Bulletin » Band 14, Nr. 5, Oktober 1971, Seite 1601 ist ein gattungsgemäßes Verfahren zur elektrischen Prüfung von Mikroverdrahtungen bekannt, welches für sehr kleine Rasterabstände, die mit federnden Kontaktstiften ausgerüsteten Adaptern nicht mehr zu prüfen sind, einsetzbar ist. Bei diesem bekannten Verfahren können zwischen den Endpunkten einer Leiterbahn und im Abstand dazu angeordneten Elektroden Gasentladungen gezündet werden. In dem Stromkreis sind dabei nacheinander die jeweilige Leiterbahn, eine erste Gasentladungsstrecke eine Gleichspannungsquelle, ein Widerstand und eine zweite Gasentladungsstrecke in Reihenschaltung angeordnet. Die Zündung von Gasentladungen zeigt dann an, daß die Leiterbahn nicht unterbrochen ist. Die über ihre Leuchtwirkung feststellbare Zündung von Gasentladungen ermöglicht somit eine Ja/Nein-Aussage über die elektrische Leitfähigkeit einer Leiterbahn.

Der Erfindung liegt die Aufgabe zugrunde, das gattungsgemäße Verfahren zur elektrischen Prüfung von Mikroverdrahtungen so zu verbessern, daß auch Fehler erkannt werden können, bei denen eine Leiterbahn nur teilweise unterbrochen ist.

Diese Aufgabe wird erfindungsgemäß dadurch gelöst, daß an die Elektroden zusätzlich eine Wechselspannung angelegt und die daraus resultierende Stromänderung zur Bestimmung des Leiterbahnwiderstandes gemessen wird.

Bei dem erfindungsgemäßen Verfahren wird also zur quantitativen Bestimmung des Leiterbahnwiderstandes zusätzlich Wechselspannung an die jeweiligen Elektroden angelegt und die daraus resultierende Stromänderung, vorzugsweise phasenempfindlich zur angelegten Wechselspannung, gemessen. Auf diese Weise können auch nur teilweise unterbrochene Leiterbahnen oder auch Leiterbahnen, die durch den Ätzprozeß eine deutliche Widerstandserhöhung erfahren haben, erkannt und nachgewiesen werden.

Das erfindungsgemäße Verfahren kann mit geringem Aufwand durchgeführt werden. Neben den Einrichtungen zur Erzeugung der Gleichspannung, der zu überlagernden Wechselspannung und zur Messung der resultierenden Stromänderungen besteht die Vorrichtung zur Durchführung des Verfahrens darin, daß in Form einer Kontaktplatte ein Isolator mit parallelen Bohrungen entsprechend den Rasterpunkten der zu prüfenden Mikroverdrahtungen vorgesehen ist, daß in diesen Bohrungen Elektroden angeordnet sind, die den der Grundplatte zugekehrten unteren Teil der Bohrung als Brennraum für eine Gasentladung freilassen, daß dieser Brennraum mit einem unter bestimmten Druck stehenden Gas gefüllt ist und daß der Isolator in einer Gasatmosphäre mit vermindertem Druck fest auf der zu prüfenden Mikroverdrahtung aufliegt, wobei die Brennräume direkt über den Rasterpunkten der Mikroverdrahtungen angeordnet sind. Vorrichtungen dieser Art sind mit den in der Lithographie bekannten Techniken sowie mit physikalisch-chemischen Prozessen der Halbleitertechnologie auf einfache Weise herstellbar und bedürfen keiner zusätzlichen Entwicklungsarbeiten.

Bei der elektrischen Ansteuerung der Gasentladungsstrecken kann weitgehend auf kommerzielle Elektronik des Plasmadisplays zurückgegriffen werden.

Die Erfindung wird anhand einer schematischen Darstellung eines Ausführungsbeispiels zur elektrischen Prüfung einer Leiterplatte erläutert.

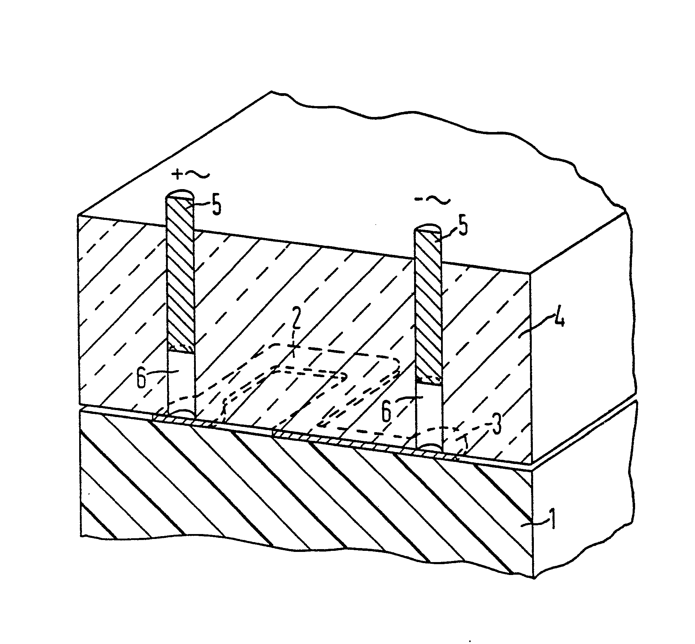

Eine Leiterplatte 1 trägt auf ihrer Deckfläche eine Leiterbahn 2 mit Lötaugen 3. In einem Isolierkörper 4, der plan auf der zu prüfenden Leiterplatte 1 aufliegt, sind im Raster Bohrungen angebracht, von denen in der Figur nur zwei im Schnitt dargestellt sind. Diese Bohrungen sind teilweise mit Elektroden 5 so ausgefüllt, daß zwischen Leiterplattenoberfläche und Elektrodenende ein Hohlraum 6 entsteht. Die gesamte Anordnung befindet sich unter vermindertem Druck (zum Beispiel einige Torr).

Es können Isolierkörper Verwendung finden, die speziell der zu prüfenden Leiterplatte angepaßt sind und nur soviele Bohrungen aufweisen, wie zu prüfende Rasterpunkte vorgesehen sind. Es ist aber auch denkbar, Isolierkörper zu verwenden, die in jedem Rasterpunkt eine Bohrung haben und nur die erforderlichen Bohrungen mit Elektroden auszufüllen.

Die Vorrichtung ist gegenüber dem Außenluftdruck abgeschlossen und wird mit einem Gas gefüllt, das auch Luft sein kann. Es wird dann im Vakuumsystem ein bestimmter verminderter Druck gegenüber dem Normaldruck hergestellt. Dieser Druck richtet sich nach der angelegten Spannung und der verwendeten Gasart sowie der Dimension des Brennraumes. Sobald der Druck eingestellt ist, wird der Isolator auf die Kontaktplatte mit der zu prüfenden Mikroverdrahtung aufgelegt. Dann wird die elektrische Prüfung durchgeführt.

Sind zwei Rasterpunkte durch eene Leiterbahn verbunden, wie es in der Figur dargestellt ist, dann werden, sobald die Zündspannung des Gases überschritten ist, zwei Gasentladungen brennen und dadurch ein Strom fließen, der in üblicher Weise nachgewiesen werden kann. Das Auftreten des Stromes ist ein Kriterium für das Intaktsein der zu prüfenden Mikroverdrahtung. Für die Messung des elektrischen Leiterbahnwiderstandes können zusätzlich phasenempfindliche Modulationsverfahren eingesetzt werden.

Das Verfahren und die Vorrichtung nach der Erfindung sind nicht auf den Einsatz bei Rastermaßen unter einem Millimeter beschränkt, sondern beispielsweise auch im Grenzbereich einsetzbar, bei dem Adaptergeräte gerade noch angewendet werden könnten.

## Patentansprüche

1. Verfahren zur elektrischen Prüfung von Mikroverdrahtungen, die im Rastermaß verdrahtet sind, zum Beispiel Leiterplatten (1), bei welchem in einem Hohlraum (6) jeweils zwischen Rasterpunkten, die durch eine Leiterbahn (2) der zu prüfenden Mikroverdrahtung verbunden sind, und Elektroden (5) durch Anlegen einer hinreichend hohen Gleichspannung an die Elektroden (5) eine elektrische Durchgängigkeit der Leiterbahn (2) anzeigende Gasentladung eintritt, dadurch gekennzeichnet, daß an die Elektroden (5) zusätzlich eine Wechselspannung angelegt und die daraus resultierende Stromänderung zur Bestimmung des Leiterbahnwiderstandes gemessen wird.

2. Verfahren nach Anspruch 1, dadurch gekennzeichnet, daß die resultierende Stromänderung phasenempfindlich zur angelegten Wechselspannung gemessen wird.

## Claims

1. A method of electrically testing micro-wirings which are wired in the grid dimensions, for example circuit boards (1), wherein a gas discharge takes place in a cavity (6) between electrodes (5) and grid points connected by a conductor path (2) of the micro-wiring which is to be tested, by the connection of a sufficiently high d. c. voltage to the electrodes (5) which discharge indicates the electrical conductivity of the conductor path (2), characterised in that an a. c. voltage is additionally connected to the electrodes (5) and the resultant change in current is measured in order to determine the conductor path resistance.

2. A method as claimed in Claim 1, characterised in that the resultant change in current is measured with phase sensitivity to the connected a. c. voltage.

## Revendications

1. Procédé pour le contrôle électrique de micro-câblages réalisés suivant une grille ayant un certain pas, par exemple de plaques à circuits imprimés (1), procédé dans lequel on produit chaque fois une décharge gazeuse dans deux cavités (6) situées respectivement entre deux points de grille reliées entre eux par une piste conductive (2) du micro-câblage à tester et des électrodes (5), par application d'une tension continue suffisamment élevée aux électrodes, l'établissement de la décharge gazeuse indiquant la continuité électrique de la piste (2), caractérisé en ce que l'on applique, en plus, une tension alternative aux électrodes (5) et on mesure la variation de courant qui en résulte pour déterminer la résistance de la piste.

2. Procédé selon la revendication 1, caractérisé en ce que l'on mesure la variation du courant avec sensibilité de phase par rapport à la tension alternative appliquée.